# EUROPÄISCHE PATENTSCHRIFT

(11) **EP 0 959 055 B1**
(45) Veröffentlichungstag und Bekanntmachung des Hinweises auf die Patenterteilung: **13.03.2002**
(21) Anmeldenummer: 99109433.5
(22) Anmeldetag: 11.05.1999
(51) Int. Cl.: C04B 35/457, C23C 14/34

(54) **Verfahren zum Herstellen eines Indium-Zinn-Oxid-Formkörpers**
Process for manufacturing indium tin oxide articles
Procédé de fabrication de pièces en oxyde d'indium étain

(30) Priorität: 20.05.1998 DE 19822570
(43) Veröffentlichungstag der Anmeldung: 24.11.1999
(73) Patentinhaber: W.C. Heraeus GmbH & Co. KG, 63450 Hanau (DE)
(72) Erfinder: Stenger, Bernd, 63546 Hammersbach (DE); Gorywoda, Marek, Dr., 63452 Hanau (DE); Lupton, David Francis, Dr., 63571 Gelnhausen (DE); Graf, Wolfram, Dr., 45133 Essen (DE); Jablonski, Wolfgang, 40822 Mettmann (DE)
(74) Vertreter: Kühn, Hans-Christian

(56) Entgegenhaltungen:
- DE-A- 4 413 344
- PATENT ABSTRACTS OF JAPAN vol. 017, no. 577 (C-1122), 20. Oktober 1993 (1993-10-20) & JP 05 170513 A (TOSOH CORP), 9. Juli 1993 (1993-07-09) -& DATABASE WPI Section Ch, Week 9332 Derwent Publications Ltd., London, GB; Class L03, AN 93-252544 XP002112571

## Beschreibung

Die Erfindung betrifft ein Verfahren zur Herstellung eines Indium-Zinn-Oxid-Formkörpers (indium-tin-oxid = ITO).

WO 9731739 offenbart u. a. ein Verfahren zur Herstellung eines Paares Sputtertargets, wobei dieses bezüglich des Sputterabbrandes endformnahe vorgeformt wird durch Verdichten eines Metallpulvers zwischen zwei massiven Platten unter heißisostatischen Preßbedingungen. Die auf jeder Seite einer entsprechenden Vorrichtung liegenden Trennplatten liegen paarweise aneinander, wobei diese durch eine keramische Trennschicht voneinander getrennt sind. Die keramische Trennschicht verhindert das Diffusionsverschweißen der entsprechenden Platten aneinander. Bei diesem Verfahren wird das Pulver im wesentlichen einaxial trotz heißisostatischen Pressens verdichtet. Ungünstig ist somit die nicht homogene Verdichtung des Indium-Zinn-Oxid-(ITO)-Preßlings.

JP-OS-5170513 offenbart ein Verfahren zur Herstellung von hochdichten ITO's (Indium-Zinn-Oxiden), die unter Verwendung von Sauerstoff als Sinteratmosphäre in einem Nickel- oder Kupferhohlgefäß gesintert werden, wobei die innere Oberfläche des Hohlgefäßes mit Aluminiumoxid und/oder Bornitrid beschichtet ist. Nachteilig bei diesem Verfahren ist die beim isostatischen Heißpressen auftretende Faltenbildung in der Hohlgefäßwand durch eine starke Schrumpfung der Pulverschüttung.

Unterschiedliche Ausdehnungskoeffizienten von ITO und Material der Hohlgefäßwand führen zur Rißbildung und Verunreinigungsgefahr für das ITO. Darüber hinaus ist ein festes Haften an der entsprechenden metallischen Wand zu beobachten; beides führt zur Rißbildung, so daß es nicht möglich ist, vorgegebene Abmessungen und Geometrien für ITO's zuverlässig herzustellen.

DE 29 39 634 C2 betrifft ein Verfahren zum Verdichten eines Metallgußteiles in der Hitze und unter isostatischem Druck (hot isostatic pressing = HIP), wobei das Gußteil mit der Oberfläche verbundene Unregelmäßigkeiten aufweist, und man einen Überzug auf eine Oberfläche des Gußteiles aufbringt, um Oberflächenöffnungen zu überbrücken, die mit den Unregelmäßigkeiten verbunden sind, und man danach zur Verdichtung das Gußteil einer Kombination aus einer ausgewählten Verarbeitungstemperatur und isostatischem Druck unterwirft. Der Überzug besteht aus einem Keramikmaterial, das bei einer Verglasungstemperatur, die geringer als die ausgewählte Verarbeitungstemperatur der HIP-Verdichtung ist, einen nichtmetallischen amorphen, im wesentlichen gasundurchlässigen Keramiküberzug ergibt. Der Überzug verschmilzt somit beim heißisostatischen Pressen.

Der thermische Expansionskoeffizient ist im Temperaturbereich von der Umgebungstemperatur bis zur ausgewählten Verarbeitungstemperatur bei der Verdichtung an den thermischen Expansionskoeffizienten der Gußteiloberfläche angepaßt.

Der Überzug bei der ausgewählten Verarbeitungstemperatur bei der Verdichtung ist viskos, wobei die Bindung des Überzuges an die Gußteiloberfläche sich während der HIP-Verdichtung abbaut.

Die Gußteiloberfläche und das Keramikmaterial werden bei der Verglasungstemperatur erwärmt und das Keramikmaterial zum Keramiküberzug verglast, wobei sich eine abbaubare Bindung an die Gußteiloberfläche ergibt.

Anschließend wird das überzogene Gußteil abgekühlt und die überzogene Gußteiloberfläche einer Kombination aus einer ausgewählten Verarbeitungstemperatur und isostatischem Druck unterworfen, um den überzogenen Teil des Gußteils zu verdichten und die Bindung zwischen dem Keramiküberzug und der Gußteiloberfläche abzubauen.

Schließlich wird das Gußteil abgekühlt und danach der Überzug von der Gußteiloberfläche entfernt.

Dieses speziell für Metallgußteile entwickelte heißisostatische Preßverfahren stellt ein außerordentlich kompliziertes und somit zeit- und kostenaufwendiges Verfahren dar, wobei darüber hinaus der viskose Überzug in pulvermetallurgisch hergestellten Kaltpreßlingen eindringen würde.

Aus dem Vorgenannten ergibt sich das Problem, mit Hilfe eines neuartigen Verfahrens, eines neuartigen Formkörpers und einer Verwendung die oben genannten Nachteile zumindest teilweise zu beseitigen. Das sich ergebende Problem liegt insbesondere darin, ITO-Formteile mit hoher Dichte auf relativ einfache Art und Weise zu erzeugen und gleichzeitig eine Verunreinigung und/oder Beschädigung der Oberfläche des Preßlings, insbesondere beim Heißpressen, zumindest zum größten Teil zu vermeiden.

Dieses Problem wird erfindungsgemäß durch ein Verfahren nach Anspruch 1 gelöst.

Beim erfindungsgemäßen Verfahren wird zunächst ein Indium-Zinn-Oxid-(ITO)-Pulver in eine erste Form gefüllt.

Von entscheidender Bedeutung beim erfindungsgemäßen Verfahren ist die Verwendung eines ITO-Pulvers, das eine spezifische BET-Oberfläche (Brunauer-Emmett-Teller) von maximal 3 m²/g bei einer mittleren Primärteilchengröße (da das Pulver sehr stark zur Bildung von Agglomeraten neigt, wird im Rasterelektronenmikroskop die Größe der einzelnen Verästelungen abgeschätzt und als Primärteilchengröße angegeben) im Bereich von 0,03 bis 1,0 µm und/oder nach dem Kaltpressen bei einem Druck von 100 MPa eine Dichte von mindestens 40 % der theoretischen Dichte (die theoretische Dichte beträgt 7,14 g/cm³) aufweist. Ein solches ITO-Pulver weist eine solch hohe Schütt- und Kaltpreßdichte auf, die ein Eindringen des im erfindungsgemäßen Verfahren verwendeten Keramikpulvers in den ITO-Preßling weitgehend verhindert.

Die die oben genannten Eigenschaften im wesentlichen aufweisenden zumindest jedoch für das erfindungsgemäße Verfahren geeigneten ITO-Pulver sind durch folgende zwei Schritte erhältlich:
1. Zunächst findet eine Reaktion mindestens zweier Reaktionspartner in einem Plasmalichtbogen einer eine Einfüllöffnung für die Reaktionspartner und eine Auslaßöffnung mit einer Gaszuführvorrichtung aufweisenden Plasmakammer zu einem Material statt, wobei als erster Reaktionspartner eine schmelzflüssige Indium-Zinn-Metall-Legierung und als zweiter Reaktionspartner Sauerstoff verwendet werden.
2. Anschließend findet eine Beaufschlagung des im Plasmalichtbogen reagierten Materials an der Auslaßöffnung der Plasmakammer mit einem Gasstrom statt, der das Material mit einer Abkühlrate im Bereich von 10⁵ K/s bis 10⁸ K/s auf eine Temperatur zwischen + 50 °C und + 400 °C abkühlt, wobei ein Indium-Zinn-Mischkristallpulver gebildet wird.

Nach diesem ersten Verfahrensschritt wird das ITO-Pulver bei einem Mindestdruck von 100 MPa kaltgepreßt. In der Regel findet dies in einer mit flüssigem Preßmedium, beispielsweise Wasser oder Öl, gefluteten Beaufschlagungskammer statt. Dabei wird das Pulver bei einem Druck von 100 MPa auf eine Dichte von mindestens 40 % der theoretischen Dichte komprimiert, um ein Eindringen von beim isostatischen Heißpressen verwendeten Keramikpulver in den Preßling weitgehend zu verhindern

Danach wird der Kaltpreßling von der ersten Form befreit und dieser in eine typischerweise aus Stahl bestehende zweite Form gegeben, in der sich Keramikpulver, in der Regel Aluminiumoxid, befindet. Die Korndurchmesserobergrenze beträgt 250 µm, wobei Schmelz- und Sintertemperatur größer als + 800 °C ist, somit oberhalb der Verfahrenstemperatur beim isostatischen Heißpressen liegt. Gleichzeitig ist die Schmelztemperatur der zweiten Form größer als + 800 °C, liegt somit über der Verfahrenstemperatur beim isostatischen Heißpressen, wobei die zweite Form unter den Bedingungen des isostatischen Heißpressens duktil ist.

Anschließend wird die zweite Form gasdicht versiegelt, beispielsweise durch Schweißen, um beim isostatischen Heißpressen einen Druckausgleich zwischen der sich in der Form und sich außerhalb der Form befindenden Atmosphäre zu verhindern.

Im Anschluß daran findet das isostatische Heißpressen des mit dem Keramikpulver benetzten Kaltpreßlings bei einer Mindesttemperatur von + 800 °C und einem Mindestdruck von 20 MPa statt. Dabei wird der ITO-Kaltpreßling hochverdichtet.

Schließlich wird der Heißpreßling nach Abkühlung von der zweiten Form befreit. Dies geschieht in der Regel durch vorsichtiges Aufsägen der HIP-Form. Durch die oben erwähnten günstigen Eigenschaften des verwendeten ITO-Pulvers wird ein Eindringen des Keramikpulvers weitgehend verhindert, wobei gleichzeitig ein Anhaften an den Innenwänden der HIP-Form ebenso wirksam unterdrückt wird.

Es hat sich in der Praxis bewährt und ist deshalb von Vorteil, wenn der Gasstrom eine Geschwindigkeit zwischen 300 m/s und 500 m/s aufweist und/oder die Abkühlrate im Bereich von 10⁶ K/s bis 10⁸ K/s liegt.

Besonders vorteilhaft ist es, wenn das Kaltpressen unter Verwendung einer ersten flexiblen Form isostatisch durchgeführt wird, um somit möglichst eine homogene Verdichtung des Pulvers zu erreichen. Die erste Form sollte im Idealfall in alle drei Raumrichtungen möglichst gleich flexibel sein, damit eine möglichst homogene Verdichtung des ITO-Pulvers beim isostatischen Kaltpressen gewährleistet ist.

In vorteilhafter Weise wird das Kaltpressen bindemittel- und/oder preßhilfsmittelfrei durchgeführt, da beim isostatischen Heißpressen keine störende Verminderung der Druckbeaufschlagungs-Effizienz durch Verdampfen der zugesetzten Mittel auftreten und keine Verunreinigung des ITO-Pulvers stattfinden soll.

Weiterhin ist es von Vorteil, wenn die erste flexible Form eine gummiartige Konsistenz aufweist, um auf diese Art und Weise eine gleichmäßige Verkleinerung bei Druckbeaufschlagung in alle drei Raumrichtungen zu gewährleisten.

Die isostatische Heißpreßform wird vorteilhafterweise vor dem isostatischen Heißpressen evakuiert, um so eine eventuell vorhandene Restfeuchte und Restgase zu entfernen. Die Feuchtigkeit führt vermutlich zu einer Zersetzung des Wassers beim isostatischen Heißpressen unter Bildung von molekularem Wasserstoff, was zu einer Deformation des HIP-Behälters und beim Öffnen dieses Behälters zu einer Wasserstoffentzündung führt. Diese beiden Nachteile werden mit dem Evakuieren vermieden und gleichzeitig die Effizienz bei der Druckbeaufschlagung gesteigert.

Die nach dem erfindungsgemäßen Verfahren hergestellten Formkörper weisen die oben angegebenen überraschenden und vorteilhaften Eigenschaften, insbesondere relativ homogene Oberflächen, auf.

Entsprechendes gilt auch für die Verwendung eines nach dem erfindungsgemäßen Verfahren hergestellten Formkörpers als Sputtertarget.

Bei Verwendung von Eisen enthaltenden isostatischen Heißpreßformen zeigt sich in vorteilhafterweise, daß der Formkörper nach dem isostatischen Heißpressen maximal 0,001 Gewichts-% Eisen aufweist, d. h., daß eine Eisenkontamination in nur äußerst geringem Maße stattfindet.

Die nachfolgenden Beispiele dienen zur Erläuterung der Erfindung.

### 1. Quaderförmiger Block:

In eine Gummiform mit den Abmessungen 135 x 180 mm werden 73 kg ITO-Pulver eingefüllt und so lange gerüttelt, bis die Füllhöhe 760 mm beträgt. Die Form wird luftdicht verschlossen und in einer kommerziellen kaltisostatischen Presse bei einem Druck von 320 MPa verdichtet. Die Gummiform wird abgezogen, um einen "Rohling" mit den Abmessungen 128 x 168 x 697 mm zu erhalten. Dieser Rohling hat ausreichende Festigkeit und
Stabilität, um eine normale Handhabung inklusive spanender Bearbeitung zur Korrektur der Formgenauigkeit zu erlauben.

Ein Behälter mit den Innenabmessungen 150 x 190 x 750 mm wird durch Schweißen von Edelstahlblechen vorbereitet, wobei der Deckel vorerst nicht aufgeschweißt wird. Auf den Boden des Behälters wird eine Schicht feinen Aluminiumoxidpulvers (mittlere Komgröße ca. 3 µm) ca. 20 mm hoch aufgeschüttet. Der kaltgepreßte ITO-Block wird auf diese Schicht gestellt und der Spalt zwischen Block und Innenwand des Behälters gleichmäßig mit dem Aluminiumoxidpulver aufgefüllt. Auch die Oberseite des ITO-Blocks wird mit Aluminiumoxidpulver zugedeckt. Anschließend wird der Deckel auf den Behälter gesetzt und mit den Seitenwänden verschweißt. Der Deckel ist mit einem Edelstahlrohr versehen, das als Absaugstutzen zur Evakuierung dient. Nach dem Aufschweißen des Deckels wird der Behälter in einen Kammerofen bei 400 °C gelegt und der Absaugstutzen an eine Vakuumpumpe angeschlossen, um die eingeschlossene Luft und auf der Pulveroberfläche adsorbierte Feuchtigkeit zu entfernen. Schließlich wird der Absaugstutzen zugeschweißt und der Behälter in eine heißisostatische Presse angeordnet, wobei dieser auf bekannte Art und Weise mit einem Druck von 40 MPa bei einer Temperatur von 970 °C sechs Stunden lang beaufschlagt wird. Nach dem Abkühlen wird der Behälter aufgetrennt und der Block ausgebaut. Dieser zeigt keinerlei Haftung an der Wand des Behälters und hat die rechteckige Form des kaltisostatisch gepreßten Blocks weitgehend rißfrei beibehalten. Die Maße sind jedoch auf 112 x 150 x 640 mm entsprechend einer Dichte von 6,79 g/cm³ geschrumpft. Die Verunreinigung an Fe beträgt 0,0005 Gewichts-%.

### 2. Zylindrisches Rohr:

Ein feingeschliffener, zylindrischer Stab aus Stahl (62 mm Durchmesser x 450 mm Länge) wird zentrisch in einen an einem Ende geschlossenen Gummischlauch (Innendurchmesser 90 mm) gestellt. Der Raum zwischen dem Stahlstab und dem Gummischlauch wird mit 6 kg ITO-Pulver ausgefüllt und der Schlauch am oberen Ende verschlossen. Analog dem ersten Beispiel wird der geschlossene Schlauch kaltisostatisch gepreßt. Nach dem Öffnen des Schlauches und vorsichtigem Entfernen des Stabs liegt der ITO-Formkörper in der Form eines Rohres (Innendurchmesser ca. 62 mm, Außendurchmesser ca. 86 mm) vor.

Das Rohr kommt in einen Stahlbehälter (siehe erstes Beispiel) und wird innen und außen mit dem oben erwähnten Aluminiumoxidpulver ausgefüllt. Nach dem Evakuieren und heißisostatischen Pressen (analog dem ersten Beispiel) wird ein Rohr mit folgenden ungefähren Abmessungen erhalten:

Innendurchmesser 60 mm, Außendurchmesser 80 mm, Länge 400 mm.

Der Rohling wird innen, außen und an den Enden überschliffen, wobei nur ein geringer Abtrag von ein bis zwei Millimetern erforderlich ist, um eine saubere, aluminiumoxidfreie Oberfläche und die erwünschte hohtzylindrische Geometrie zu erzielen.

Grundsätzlich können durch Schleifen des erhaltenen Heißpreßlings Formkörper unterschiedlicher Geometrie erhalten werden.

## Patentansprüche

1. Verfahren zur Herstellung eines Indium-Zinn-Oxid-Formkörpers, **gekennzeichnet durch** folgende Schritte:
a. Einfüllen eines Indium-Zinn-Oxid-Pulvers in eine erste Form, wobei das Indium-Zinn-Oxid-Pulver eine spezifische BET-Oberfläche von maximal 3 m²/g bei einer mittleren Primär-eilchengröße im Bereich von 0,03 bis 1,0 um aufweist und/oder das Indium-Zinn-Oxid-Pulver nach dem Kaltpressen bei einem Druck von 100 MPa eine Dichte von mindestens 40 % der theoretischen Dichte aufweist und/oder erhältlich ist **durch**:
Reaktion mindestens zweier Reaktionspartner in einem Plasmalichtbogen einer eine Einfüllöffnung für die Reaktionspartner und eine Auslassöffnung mit einer Gaszufuhrvorrichtung aufweisenden Plasmakammer zu einem Material, wobei als Reaktionspartner eine schmelzflüssige Indium-Zinn-Metall-Legierung und als zweiter Reaktionspartner Sauerstoff verwendet werden und
Beaufschlagung des im Plasmalichtbogen reagierten Materials an der Auslassöffnung der Plasmakammer mit einem Gasstrom, der das Material mit einer Abkühlrate im Bereich von 105 K/s bis 108 K/s auf eine Temperatur zwischen + 50 °C und + 400 °C abkühlt, wobei ein Indium-Zinn-Mischkristallpulver gebildet wird;
b. Kaltpressen des Indium-Zinn-Oxid-Pulvers bei einem Mindestdruck von 100 MPa;
c. Eingeben des von der ersten Form befreiten Kaltpresslings in ein sich in einer zweiten Form befindenden Keramikpulvers, dessen Komdurchmesserobergrenze 250 um beträgt und dessen Schmelz- und Sintertemperatur größer als + 800 °C ist, wobei die Schmelztemperatur der zweiten Form größer als 800 °C und die Form unter den Bedingungen des isostatischen Heißpressens duktil ist;
d. gasdichtes Versiegeln der zweiten Form;
e. isostatisches Heißpressen des mit dem Keramikpulver benetzten Kaltpresslings bei einer Mindesttemperatur von + 800 °C und einem Mindestdruck von 20 MPa.

2. Verfahren nach Anspruch 1, **dadurch gekennzeichnet, dass** der Gasstrom eine Geschwindigkeit zwischen 300 m/s und 500 m/s aufweist.

3. Verfahren nach Anspruch 1 oder 2, **dadurch gekennzeichnet, dass** die Abkühlrate im Bereich von 106 K/s bis 108 K/s liegt.

4. Verfahren nach einem der Ansprüche 1 bis 3, **dadurch gekennzeichnet, dass** das Kaltpressen unter Verwendung einer ersten flexiblen Form isostatisch durchgeführt wird.

5. Verfahren nach einem der Ansprüche 1 bis 4, **dadurch gekennzeichnet, dass** das Kaltpressen bindemittel- und/oder presshilfsmittelfrei durchgeführt wird.

6. Verfahren nach einem der Ansprüche 1 bis 5, **dadurch gekennzeichnet, dass** die erste flexible Form eine gummiartige Konsistenz aufweist.

7. Verfahren nach einem der Ansprüche 1 bis 6, **dadurch gekennzeichnet, dass** die isostatische Heißpreßform vor dem isostatischen Heißpressen evakuiert wird.

## Claims

1. Process for the manufacture of an indium tin oxide formed body, **characterized by** the following steps:
a. filling of a first die with an indium tin oxide powder having a specific BET surface area of 3 m²/g maximum with a mean primary particle size in the range 0.03 to 1.0 µm and/or having a density of at least 40% of the theoretical density after cold pressing at a pressure of 100 MPa and/or being obtainable by:
reaction of at least two reactants in a plasma arc of a plasma chamber having a filler opening for the reactants and an outlet opening with a gas supply arrangement, to form a material, a fused indium tin metal alloy being used as reactant and oxygen being used as second reactant and
exposure of the material reacted in the plasma arc, at the outlet opening of the plasma chamber, to a gas stream which cools the material at a cooling rate in the range 105 K/s to 108 K/s to a temperature between +50°C and +400°C, forming an indium tin mixed crystal powder;
b. cold pressing of the indium tin oxide powder at a minimum pressure of 100 MPa;
c. insertion of the cold-pressed compact stripped from the first die into a second die containing a ceramic powder whose upper limit of particle size is 250 µm and whose melting-point and sintering temperature is higher than +800°C, the second die having a melting-point higher than 800°C and being ductile under the conditions of isostatic hot pressing;
d. gastight sealing of the second die;
e. isostatic hot pressing of the cold-pressed compact wetted with the ceramic powder, at a minimum temperature of +800°C and a minimum pressure of 20 MPa.

2. Process according to Claim 1, **characterized in that** the gas stream has a flow rate of between 300 m/s and 500 m/s.

3. Process according to Claim 1 or Claim 2, **characterized in that** the cooling rate lies in the range 106 K/s to 108 K/s.

4. Process according to any one of Claims 1 to 3, **characterized in that** the cold pressing is performed isostatically using a first flexible die.

5. Process according to any one of Claims 1 to 4, **characterized in that** the cold pressing is performed without the use of binding agents and/or pressing aids.

6. Process according to any one of Claims 1 to 5, **characterized in that** the first flexible die has a rubber-like consistency.

7. Process according to any one of Claims 1 to 6, **characterized in that** the isostatic hot-pressing die is evacuated before isostatic hot pressing takes place.

## Revendications

1. Procédé de fabrication d'un corps moulé en oxyde indium-étain, **caractérisé par** les étapes suivantes :
a. on remplit un premier moule avec une poudre d'oxyde indium-étain qui présente une surface BET spécifique de 3m²/g au maximum pour une taille de particules primaires moyenne située dans la plage de 0,03 à 1,0 µm et/ou qui, après pressage à froid à une pression de 100 MPa, présente une densité d'au moins 40 % de la densité théorique et/ou qui peut être obtenue par :
réaction d'au moins deux partenaires de réaction dans un arc au plasma d'une chambre à plasma présentant une ouverture de remplissage pour les partenaires de réaction et une ouverture de sortie avec un dispositif d'amenée de gaz pour former un matériau, en utilisant un alliage métallique indium-étain en fusion comme partenaire de réaction et de l'oxygène comme deuxième partenaire de réaction, et par
alimentation du matériau ayant réagi dans l'arc au plasma à l'ouverture de sortie de la chambre à plasma par un flux de gaz qui refroidit le matériau avec un taux de refroidissement dans la plage de 10⁵ K/s à 10⁸ K/s, jusqu'à une température entre + 50°C et + 400°C, en formant une poudre cristalline mixte indium-étain ;
b. on presse à froid la poudre d'oxyde indium-étain avec une pression minimum de 100 MPa ;
c. on introduit la pièce pressée à froid libérée du premier moule dans une poudre céramique se trouvant dans un deuxième moule, dont la limite supérieure de diamètre de grain est de 250 µm et dont la température de fusion et de frittage est supérieure à + 800°C, la température de fusion du deuxième moule étant supérieure à + 800°C et le moule étant ductile dans les conditions de pressage à chaud isostatique.
d. on réalise un étanchement du deuxième moule vis-à-vis des gaz ; et
e. on presse à chaud et de manière isostatique la pièce pressée à froid humectée de poudre céramique à une température minimum de + 800°C et une pression minimum de 20 MPa.

2. Procédé selon la revendication 1, **caractérisé en ce que** le flux de gaz présente une vitesse entre 300 m/s et 500 m/s.

3. Procédé selon l'une ou l'autre des revendications 1 et 2, **caractérisé en ce que** le taux de refroidissement est situé dans la plage de 10⁶ K/s à 10⁸ K/s.

4. Procédé selon l'une quelconque des revendications 1 à 3, **caractérisé en ce que** le pressage à froid est effectué de manière isostatique en utilisant un premier moule flexible.

5. Procédé selon l'une quelconque des revendications 1 à 4, **caractérisé en ce que** le pressage à froid est effectué sans liant et/ou sans agent auxiliaire de pressage.

6. Procédé selon l'une quelconque des revendications 1 à 5, **caractérisé en ce que** le premier moule flexible présente une consistance analogue à celle du caoutchouc.

7. Procédé selon l'une quelconque des revendications 1 à 6, **caractérisé en ce que** le moule à chaud isostatique est évacué avant le pressage à chaud isostatique.
